# EUROPÄISCHE PATENTSCHRIFT

(11) **EP 1 909 110 B1**
(45) Veröffentlichungstag und Bekanntmachung des Hinweises auf die Patenterteilung: **22.12.2010**
(21) Anmeldenummer: 07019310.7
(22) Anmeldetag: 02.10.2007
(51) Int. Cl.: G01R 33/28, A61B 5/055

(54) **Anlage zur Untersuchung von Objekten mittels magnetischer Resonanz**
Facility for investigating objects using magnetic resonance
Installation destinée à l'analyse d'objets par résonance magnétique

(30) Priorität: 05.10.2006 DE 102006047589
(43) Veröffentlichungstag der Anmeldung: 09.04.2008
(73) Patentinhaber: Bruker BioSpin MRI GmbH, 76275 Ettlingen (DE)
(72) Erfinder: Gewiese, Bernd, Dr., 75334 Straubenhardt-Conweiler (DE)
(74) Vertreter: Kohler Schmid Möbus

(56) Entgegenhaltungen:
- DE-A1-102004 008 343
- US-A1- 2004 251 905

## Beschreibung

Die Erfindung betrifft eine Anlage zur Untersuchung von Objekten mittels magnetischer Resonanz mit einem Sicherheitsraum, der gasdichte Wände aufweist, und mit einem Magnetsystem zur Erzeugung eines homogenen Magnetfelds in einem Untersuchungsvolumen, wobei das Magnetsystem eine gasdichte Außenhülle aufweist, die in einem Hüllenbereich durch Durchführungen ins Innere des Magnetsystems durchbrochen ist.

Derartige Anlagen sind beispielweise aus der Offenlegungsschriften US 2005/200360 A1 und US 2004/0251905 A1 bekannt.

Forschungsarbeiten in Zusammenhang mit hochinfektiösen durch Aerosol übertragbare Viren zur Entwicklung von Impfstoffen und Therapien, sowie die Forschung mit genetisch manipulierten und biologisch, chemisch oder radioaktiv verseuchte Objekte und giftigen Kampfstoffen (ABC-Waffen) erfordern ein hohes Maß an Sicherheitsvorherkehrungen. Derartige Objekte müssen daher in einem Sicherheitsraum untersucht werden, von dem kein Gasaustausch mit der Umgebung stattfinden darf. Die Auflagen für derartige Sicherheitsräume sind z.B. in der Broschüre "Laboratory Biosafety Manual", Third Edition 2004, der WHO beschrieben, insbesondere auf den Seiten 2 und 3. In vielen Fällen sind die Anforderungen des dort beschriebenen Biosafety Level 4 zu erfüllen. Zur Erforschung oben genannter Objekte sind unter anderem Messungen mittels magnetischer Resonanz interessant. Da innerhalb des Sicherheitsraums angeordnete Apparaturen jedoch ebenfalls kontaminiert werden, können diese zur Untersuchung nicht kontaminierter Objekte nicht mehr verwendet werden. Für die Untersuchung kontaminierter und nicht kontaminierter Objekte sind daher im Allgemeinen separate Apparaturen notwendig. Die Anschaffung mehrerer Apparaturen zur Messung magnetischer Resonanzen ist jedoch mit einem nicht unerheblichen Kostenaufwand verbunden.

Ein weiteres Problem stellt die Wartung von in kontaminierten Räumen angeordneten Apparaturen dar, da sich das Wartungspersonal während der Wartung, zum Beispiel zum Auffüllen von flüssigem Helium für die supraleitenden Spulen der Apparatur, im Sicherheitsraum aufhalten muss. Dies erfordert einen zusätzlichen Aufwand an Sicherheitsmaßnahmen zum Schutz des Personals (Schutzanzüge, Entsorgung der Schutzkleidung, Gesundheitsüberwachung des Personals usw.) und birgt beträchtliche Risiken für das technische Personal, zumal die mit der Kontamination verbundenen Risiken insbesondere vom technischen Personal oft unterschätzt werden. Ein Großteil der Wartungsarbeiten wird daher in der Regel von wissenschaftlich geschultem Personal durchgeführt, wodurch die Wartungskosten unnötig erhöht werden.

Speziell für die Untersuchung von beispielsweise genmanipulierten Tieren sind verschärfte Sicherheitsbedingungen notwendig, um ein Entkommen der Tiere zu verhindern. Die Tiere werden zwar im Allgemeinen narkotisiert untersucht, im Falle eines frühzeitigen Erwachens der Tiere muss jedoch verhindert werden, dass die genmanipulierten Tiere in die Freiheit entkommen.

In der o.g. Offenlegungsschrift werden die angesprochenen Probleme dadurch gelöst, dass sich der Magnet außerhalb des Sicherheitsraums befindet, das Untersuchungsvolumen jedoch innerhalb. Dies wird erreicht, indem der Sicherheitsraum einen Fortsatz aufweist, der in das Magnetsystem hineinragt und das Untersuchungsvolumen umschließt.

Eine solche Ausstülpung ist jedoch topologisch kompliziert und schwierig zu fertigen, wenn man berücksichtigt, dass sie auch bei Störfällen dicht bleiben muss. Zudem weicht das Design der Anlage erheblich von den bisherigen MRI-Untersuchungsräumen mit integrierter Hochfrequenz(=HF)-Abschirmung ab, was Aufwand und Kosten weiter erhöht.

Die weitaus häufigsten Wartungsaufgaben durch nicht-wissenschaftliches Personal finden am Magnetsystem statt und es erscheint durchaus akzeptabel, die Anlage so auszugestalten, dass nur bei diesen Arbeiten der Sicherheitsraum nicht betreten werden muss.

Aufgabe der Erfindung ist es daher, eine Anlage zur Untersuchung kontaminierter Objekte mittels magnetischer Resonanz vorzuschlagen, bei der eine einfache Wartung des Magnetsystems ohne Kontaminationsgefahr für das Wartungspersonal ermöglicht wird, die möglichst einfach und robust ist und wenig von Standard-Untersuchungsräumen abweicht.

Diese Aufgabe wird auf überraschend einfache, aber wirkungsvolle Weise durch eine Anlage mit den eingangs beschriebenen Merkmalen gelöst, bei der das Magnetsystem im Sicherheitsraum angeordnet ist, wobei eine der gasdichten Wände in einem Zugangsbereich durchbrochen ist und ein gasdichtes Verbindungselement zwischen dem Zugangsbereich und dem Hüllenbereich vorliegt, das an seinen Enden mit der gasdichten Wand und der gasdichten Außenhülle jeweils gasdicht verbunden ist, sodass ein Zugang von außerhalb des Sicherheitsraums zum Hüllenbereich und den dortigen Durchführungen besteht, der gegen den Sicherheitsraum gasdicht abgedichtet ist.

Damit wird ein Teil der gasdichten Hülle des Magnetsystems effektiv zu einem Teil der Wand des Sicherheitsraums, während der vom Verbindungselement umschlossene Hüllenbereich für Wartungszwecke zugänglich wird.

Der Sicherheitsraum oder zumindest ein Messraum innerhalb des Sicherheitsraums ist in vorteilhafter Weise als HF-dichter Faraday-Käfig ausgebildet. Das Verbindungselement und der Teil der Außenhülle, der nicht zum umschlossenen Hüllenbereich zählt, bilden dann auch einen Teil des Faraday-Käfigs, der den Sicherheitsraum bzw. den Messraum HF-mäßig abdichtet.

Die erfindungsgemäße Anlage erlaubt eine topologische Trennung des Wartungsbereichs der Magnetanordnung vom Sicherheitsraum. Die technische Betreuung und Wartung des Magnetsystems kann daher durch Techniker erfolgen, ohne dass diese den Sicherheitsbereich betreten müssen. Eine unnötige Gefährdung des technischen Personals wird durch die erfindungsgemäße Anlage vermieden. Zudem bewirkt die Anlage eine verbesserte Sicherung der zu untersuchenden Objekte gegenüber der Außenwelt, da das Risiko des Austritts einer Kontamination und/oder des Objekts selbst dadurch reduziert wird, dass der Sicherheitsraum für diese Zwecke nicht betreten werden muss. Andererseits ist diese Anordnung topologisch einfacher als die der eingangs geschilderten Anlage, was sie robuster und tendenziell gegen Lecks sicherer macht.

Besonders wirksam treten die Vorteile der Erfindung bei einer Ausführungsform zu Tage, bei der das zu untersuchende Objekt kontaminiert und der Sicherheitsraum so ausgestaltet ist, dass keine Kontamination aus dem Sicherheitsraum nach außen dringen kann, insbesondere wenn die Anforderungen des oben angesprochenen Biosafety Levels 4 erfüllt sein müssen.

Vorzugsweise herrscht im Sicherheitsraum gegenüber der Außenatmosphäre Unterdruck. Hierdurch ist gewährleistet, dass bei einem eventuellen Auftreten einer Leckage der Anlage ein Gastransfer von außen in den Sicherheitsraum hinein erfolgt und nicht umgekehrt.

Es ist vorteilhaft, wenn der Sicherheitsraum durch zumindest eine Schleuse zugänglich ist. Aufgrund des im Allgemeinen kleinen Volumens der Schleuse können giftige Gase oder Aerosole relativ schnell aus dem Schleusenraum abgepumpt werden. Dies ist insbesondere zum Wechseln und Entsorgen kontaminierter Schutzkleidung vorteilhaft.

In einer besonders bevorzugten Ausführungsform der Erfindung ist der Sicherheitsraum mit einem Luftfilterungssystem 1d ausgestattet oder an ein solches angeschlossen. Mit giftigen Stoffen bzw. mit Viren verseuchte Luft kann durch das Luftfilterungssystem 1d aus dem Raum abgepumpt, gefiltert und gereinigt werden. Mit Hilfe eines kontrollierten Luftaustausches wird das Betreten des Sicherheitsraums, beispielsweise zur Entnahme des Objekts, erheblich erleichtert.

In einer vorteilhaften Ausführungsform der Erfindung ist das zu untersuchende Objekt während der Untersuchung in einem geschlossenen Behälter angeordnet. Insbesondere kleine Objekte können auf diese Weise einfach gehandhabt werden.

Ein Entkommen beispielsweise eines zu untersuchenden Tieres aus dem Labor wird dadurch erschwert.

Des Weiteren kann es vorteilhaft sein, wenn im Sicherheitsraum Einmal-HF-Antennen vorgesehen sind, die nach Benutzung entsorgt werden, so dass eine Übertragung der Kontamination über eine bereits verwendete HF-Antenne auf ein anderes Objekt vermieden wird.

Angrenzend an den Sicherheitsraum ist vorzugsweise ein Bedien- und/oder Wartungsraum angeordnet, in dem sich eine Konsole und/oder ein Netzgerät befinden. Das Innere des Sicherheitsraums kann durch ein gas- und HF-dichtes Fenster eingesehen werden. Dies hat den Vorteil, dass der Betreiber der Anlage nicht persönlich den Sicherheitsraum betreten muss und dennoch das Magnetsystem mit dem Untersuchungsvolumen im Auge hat.

In vorteilhafter Weise befindet sich in der Wand zwischen diesen beiden Räumen auch eine Filterplatte, die gas- und HF-dicht ist und durch die Leitungen vom und zum Magnetsystem führen. Es müssen nicht alle Leitungen über das Verbindungselement laufen, was topologisch aufwändig ist. Fest installierte, wartungsarme Verbindungen können auch direkt durch die Filterplatte geführt werden.

Vorzugsweise ist die durchbrochene Wand die Decke des Sicherheitsraums. Die Durchführungen ins Innere des Magnetsystems sind in der Regel oben angebracht oder können dahin verlagert werden. Bei einem supraleitenden Magnetsystem sind dies im Wesentlichen der oder die Türme des Kryostaten mit den Öffnungen für die Zu- und Abfuhr der verflüssigten Gase sowie für elektrische Durchführungen, insbesondere zum Laden und Entladen der Magnetspule oder ein Kaltkopf eines Refrigerators.

Das Verbindungselement besteht vorzugsweise aus Metall, insbesondere aus Edelstahl. Metalloberflächen lassen sich besonders gut dekontaminieren. Zudem übernimmt eine metallische Wand die weitere Funktion der HF-Abschirmung des Untersuchungsraums.

Vorzugsweise ist das Verbindungselement an die durchbrochene Wand und/oder an die gasdichte Außenhülle angeschweißt. Eine Schweißverbindung ist mechanisch belastbar, zuverlässig gasdicht und auch HF-dicht.

Besonders bevorzugt ist, dass das Verbindungselement aus einem ersten Teilverbindungselement besteht, das fest mit der durchbrochenen Wand verbunden ist, sowie aus einem zweiten Teilverbindungselement, das fest mit der gasdichten Außenhülle verbunden ist, und dass die beiden Teilverbindungselemente ihrerseits gasdicht verbunden sind. Dies erleichtert die Montage und (zeitweilige) Demontage der Anlage.

Vorzugsweise sind die Verbindung des Verbindungselements mit der Wand und/oder der gasdichten Hülle und/oder die Verbindung der Teilverbindungselemente untereinander Schweißverbindungen, was mechanische Festigkeit und Dichtheit sicherstellt.

Vorteilhaft ist eine Ausführungsform, bei der die Form des Verbindungselements trichterförmig ist mit einer größeren Öffnung auf der Wandseite, derart, dass von außerhalb des Sicherheitsraums ein bequemerer Zugang zu den Durchführungen entsteht.

Die Erfindung ist besonders vorteilhaft, wenn das Magnetsystem eine supraleitende Magnetspule umfasst und die gasdichte Hülle der Außenmantel eines Magnetkryostaten ist. In diesem Fall liegen die Durchführungen besonders günstig.

Vorzugsweise umfassen dabei die Durchführungen solche für Stromzuleitungen zur Magnetspule und/oder zu Shimspulen und/oder Einfüll- und Abdampfleitungen und/oder Quenchleitungen für im Kryostaten vorhandene kryogene Fluide, insbesondere Helium. Dies sind die wartungsintensivsten Komponenten des Magnetsystems. Insbesondere die Quenchleitung muss sicher nach außen geführt werden, um im Quenchfall im Sicherheitsraum nicht zu einem Überdruck zu führen, was dessen Funktion negativ beeinträchtigen könnte.

Der Kaltkopf eines etwaig vorhandenen Refrigerators des Kryostaten wird vorteilhaft im Hüllenbereich angeordnet. Er kann dann durch das Verbindungselement von außerhalb des Sicherheitsraums versorgt, gewartet und/oder ausgetauscht werden.

Das Verbindungselement oder eines oder beide der Teilverbindungselemente können flexible Abschnitte enthalten, vorzugsweise in Form eines (metallischen) Faltenbalgs. Damit kann zur Montage und/oder Justage die Position des Magnetsystems relativ zur Wand leicht verändert werden. Insbesondere bei der Montage können kleine Toleranzen leicht ausgeglichen werden.

Für den Fall, dass sich in einer Störsituation ein Überdruck innerhalb des Magnetsystems bis zur Außenhülle ausbreitet, z.B. wenn bei einem Quench eines supraleitenden Magneten der Heliumtank reißt und ein Überdruck im Vakuumteil entsteht, ist üblicherweise ein großflächiges Überdruckventil an der Außenhülle vorgesehen. Es ist nun vorteilhaft, dieses Überdruckventil mit einer Überdruckleitung zu versehen, die durch eine gasdichte Durchführung durch das Verbindungselement aus dem Sicherheitsraum herausführt. Dadurch wird vermieden, dass in diesem extremen Störfall Helium in den Sicherheitsraum eintritt, dort Personal gefährdet oder zu einem Überdruck führt.

Weitere Vorteile der Erfindung ergeben sich aus der Beschreibung und der Zeichnung. Ebenso können die vorstehend genannten und die noch weiter aufgeführten Merkmale je für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

Es zeigen:
- **Fig. 1**: schematisch eine erfindungsgemäße Anlage zur Untersuchung von Objekten mittels magnetischer Resonanz in einem Sicherheitsraum mit integriertem Faraday-Käfig und supraleitendem Magnetsystem in einer Draufsicht;
- **Fig. 2**: schematisch einen Ausschnitt der Anlage der Fig. 1 in einer Seitenansicht quer zur horizontalen Längsachse des supraleitenden Magnetsystems;
- **Fig. 3**: schematisch einen Ausschnitt der Anlage der Fig. 1 in einer Seitenansicht längs der horizontalen Längsachse des supraleitenden Magnetsystems;

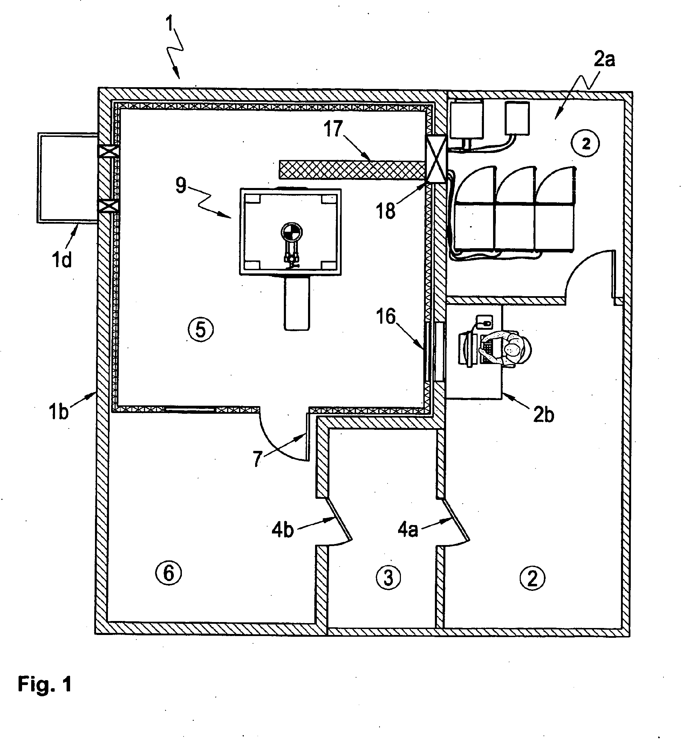

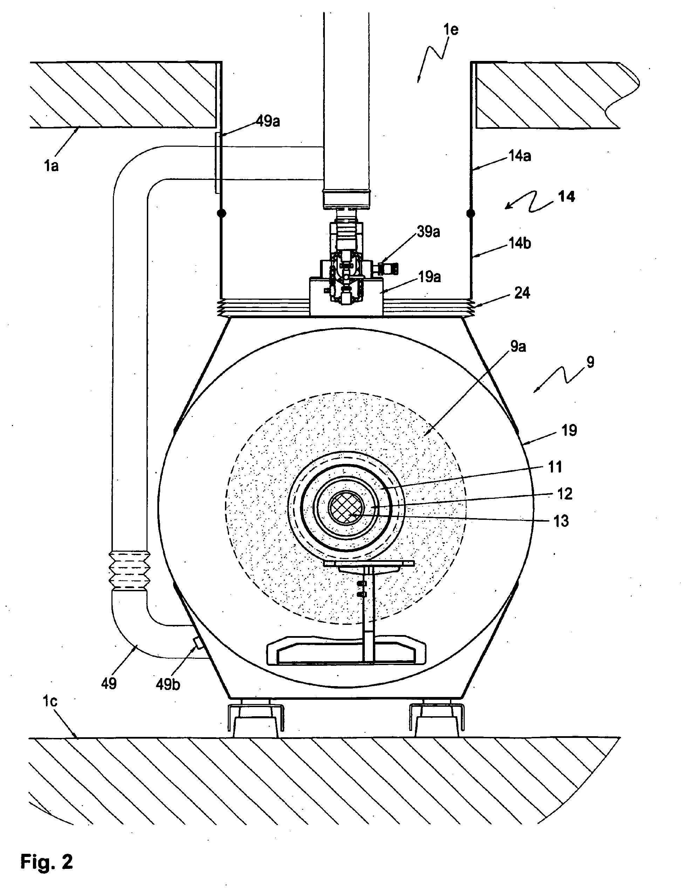

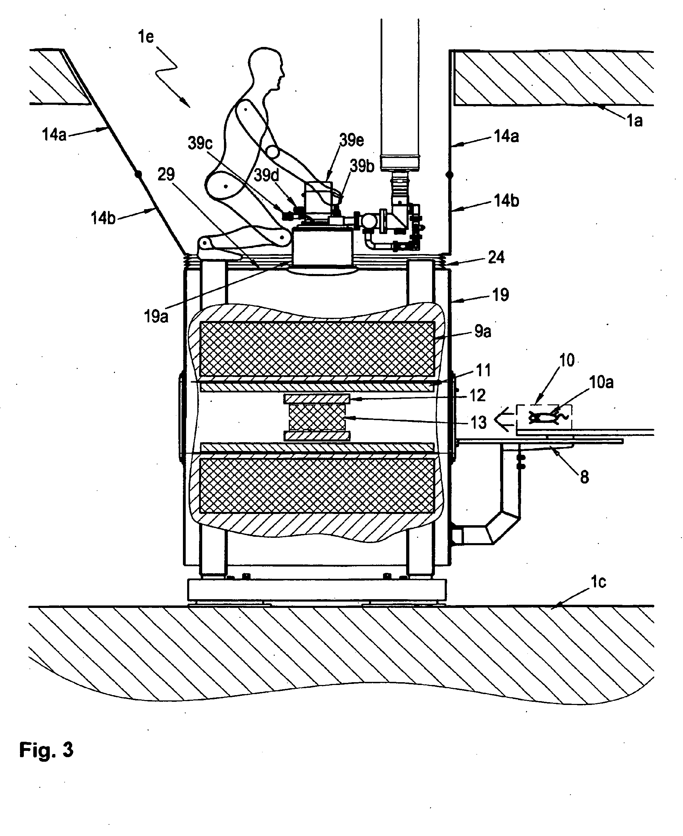

Die **Fign. 1** bis **3** werden gemeinsam besprochen und zeigen ein Ausführungsbeispiel einer Anlage zur Untersuchung von Objekten mittels magnetischer Resonanz, die einen Sicherheitsraum **1** umfasst. Der Sicherheitsraum 1 kann von einem Bedien- und Wartungsraum **2** her über die gasdicht schließenden und druckfesten Türen **4a** und **4b** durch eine Schleuse **3** betreten werden. Der Sicherheitsraum 1 ist in einen Messraum **5** und einen Objektvorbereitungsraum **6** aufgeteilt, welche ebenfalls durch eine HF-dichte Tür **7** voneinander getrennt sind. Der Messraum ist (unter Einschluss des noch zu besprechenden Verbindungselements 14 und der Außenhülle 19 des Magnetsystems 9) als Faraday-Käfig ausgebildet. Im Sicherheitsraum 1 befinden sich sämtliche für die Experimente notwendigen Mess- und Narkoseeinrichtungen. Das Messobjekt 10a kann auf einer verfahrbaren Objektliege 8 für die Messung vorbereitet werden.

Im Messraum 5 ist ein supraleitendes Magnetsystem 9 angeordnet, welches auch Shim- und Gradientenspulen 11 und einen oder mehrere Resonatoren 12 umfasst. Das Untersuchungsvolumen 13, in dem die Messungen mittels magnetischer Resonanzen vorgenommen werden, liegt innerhalb eines Resonators 12 und wird dementsprechend vom Magnetsystem 9 umschlossen.

Die Wände des Sicherheitsraums 1, d.h. Decke 1a, Seitenwände 1b und Boden 1c sind gasdicht und bestehen weitgehend aus Metall. Die Decke 1a ist in einem Zugangsbereich 1e oberhalb des Magnetsystems 9 durchbrochen. Ein trichterförmiges Verbindungselement 14 aus Edelstahl verbindet die durchbrochene Decke 1a mit der Edelstahl-Außenhülle 19 des Magnetsystems 9. Das Verbindungselement 14 besteht aus zwei Teilen 14a, 14b, die im montierten Zustand gasdicht miteinander verschweißt sind. Das erste Teil 14a ist gasdicht mit der Decke 1 a verschweißt. Das zweite Teil 14b ist mit der gasdichten Außenhülle 19 des Magnetsystems 9 gasdicht verschweißt und weist einen Faltenbalg 24 aus Edelstahl auf derart, dass ein Hüllenbereich 29 der Außenhülle 19 effektiv außerhalb des Sicherheitsraums 1 liegt und von diesem durch das angeschweißte Verbindungselement 14 gasdicht getrennt und von außen über den Zugangsbereich 1e zugänglich ist. In diesem Hüllenbereich 29 befinden sich vorwiegend an den Türmen 19a des Kryostaten Durchführungen 39a -39d ins Innere des Magnetsystems 9, hier eines Kryostaten mit horizontaler Bohrung, der eine supraleitende Magnetspule enthält. Weiter befindet sich in diesem Hüllenbereich 29 der Kaltkopf 39e eines Refrigerators, der im Innern Strahlungsschilde bzw. abdampfendes Helium kühlt und zu dem elektrische und Gaszuleitungen führen. Der generelle Aufbau eines solchen Magnetsystems 9 ist Stand der Technik und braucht nicht weiter erläutert werden. Die Durchführungen 39a-39d und der Kaltkopf 39e des Refrigerators sind im Normalbetrieb der Anlage weitgehend verschlossen (abgesehen von einer Abdampfleitung für verdampfendes Helium). Für Wartungszwecke, z.B. Einführung von Stromstäben zum Laden (Entladen) der Spule, Einführen eines Hebers zum Nachfüllen von Helium, Öffnen des Kaltkopfgehäuses zu Reinigungszwecken oder dem Austausch von Teilen können sie jedoch geöffnet werden, ohne den Sicherheitsraum 1 zu betreten. Die Gaszuleitungen zum Kaltkopf 39e bilden im Normalbetrieb ein geschlossenes System unter Einschluss eines externen Kompressors. Im Fall eines Quenchs der Magnetspule 9a im Kryostaten 9 muss eine Abdampfleitung mit großem Querschnitt freigegeben werden, die sog. Quenchleitung. Alle diese Zu- und Ableitungen führen von außen durch das Verbindungselement 14 zu den Durchführungen 39a-d im Hüllenbereich 29 bzw. zurück. Zudem muss der Hüllenbereich 29 von außen für Wartungszwecke zugänglich sein. Aus diesem Grund hat das Verbindungselement 14 insgesamt eine Trichterform. Die Teilung in zwei Teilbereiche 14a, 14b, die jeweils fest mit der Raumdecke 1 a bzw. der Kryostatenhülle 19 verbunden sind, erlaubt eine relativ einfache Montage bzw. Demontage nach Dekontamination des Sicherheitsbereichs 1 mit einer Auftrennung an einer relativ unkritischen und zugänglichen Stelle. Nach einer Trennung können die Teilelemente 14a, 14b an der Decke 1a bzw. am Kryostaten 9 verbleiben, wenn beabsichtigt ist, diese später wieder zusammenzufügen. Der Faltenbalg 24 erlaubt ein einfaches Zusammenfügen vor dem Verschweißen und wirkt zudem schwingungsdämpfend.

Mittels der verfahrbaren Objektliege 8 kann ein vorbereitetes Objekt 10a in das Untersuchungsvolumen 13 transferiert werden. Die Messkonsole **2b** der Apparatur und etwaige Netzgeräte **2a** sind vorzugsweise in einem weiteren Raum **2** untergebracht, der nicht den Sicherheitsansprüchen des Sicherheitsraums 1 unterliegt und somit frei zugänglich ist. Leitungen **17** führen von der Konsole 2b bzw. dem Netzgerät 2a durch eine gas- und HF-dichte Filterplatte **18** in der Wand zum Magnetsystem. Diese Leitungen 17 können die HF-Zuleitungen zu den Resonatoren 12, Stromzuführungen zum Shim- und Gradientensystem 11 oder auch Leitungen zur Versorgung des Messobjekts 10 sowie Kühlflüssigkeitszuführungen für das Gradientensystem 11 umfassen.

Während der Messung von magnetischen Resonanzen werden Hochfrequenzpulse von einer HF-Antenne (Resonator) 12 ausgesandt und empfangen. Für manche Untersuchungen ist es notwendig, die HF-Empfangsantennen 12 sehr nahe an oder sogar in Kontakt mit dem zu untersuchenden Objekt 10a zu bringen. Die Erfindung sieht daher vor, für solche Anwendungen HF-Mess- und/oder Sende-Antennen 12 im Sicherheitsraum bereitzustellen, bei denen es sich um Einmal-Spulen handelt, die nach der Untersuchung des Objekts 10a entsorgt werden können, um eine Kontamination der nachfolgend zu untersuchenden Objekte durch die kontaminierten HF-Empfangsantennen 12 zu vermeiden. Die von der HF-Mess-und/oder Sende-Antenne 12 empfangenen Messsignale werden dann vom Sicherheitsraum 1 zur Konsole 2b mittels elektrischer Leitungen, 17 die durch die gasdichte Filterplatte 18 geführt sind, oder auch mittels drahtloser, insbesondere optischer Signalübertragungsmittel, übertragen.

Im unteren Bereich der Außenhülle 19 des Magnetsystems befindet sich ein Überdruckventil **49b** des Vakuumteils des Kryostaten 9. Dieses Überdruckventil 49b ist über eine Überdruckleitung **49** mit einer Durchführung **49a** durch das Verbindungselement 14 verbunden, so dass im Störfall mit Überdruck aus dem Magnetsystem austretendes Gas nicht in den Sicherheitsraum 1 gelangt.

Die erfindungsgemäße Anlage ist nicht nur zur Verwendung in Zusammenhang mit bildgebenden magnetischen Resonanzmessungen (MRI) beschränkt, sondern ist auch interessant zur Durchführung von z.B. ESR- oder NMR-Spektroskopie, insbesondere zur Untersuchung von ABC-Kampfstoffen. Hierzu ist beispielsweise denkbar ein Magnetsystem mit vertikaler Bohrung zu verwenden.

Insgesamt ergibt sich eine Anordnung zur Messung magnetischer Resonanzen mit deren Hilfe hochkontaminierte Objekte, die mit einem besonderen Risiko für die menschliche Gesundheit und/oder die Umwelt verbunden sind, untersucht werden können, wobei die erfindungsgemäße Anlage eine einfache und risikoarme Wartung des Magnetsystems erlaubt. Das Wartungspersonal wird daher keiner unnötigen Gefahr ausgesetzt, so dass die Wartung der Apparatur von einem technischen Personal durchgeführt werden kann.

## Patentansprüche

1. Anlage zur Untersuchung von Objekten (10a) mittels magnetischer Resonanz mit einem Sicherheitsraum (1), der gasdichte Wände (1a-c) aufweist, und mit einem Magnetsystem (9) zur Erzeugung eines homogenen Magnetfelds in einem Untersuchungsvolumen (13), wobei das Magnetsystem (9) eine gasdichte Außenhülle (19) aufweist, die in einem Hüllenbereich (29) durch Durchführungen (39a-d) ins Innere des Magnetsystems (9) durchbrochen ist, wobei das Magnetsystem (9) im Sicherheitsraum (1) angeordnet ist und der Hüllenbereich (29) gegen den Sicherheitsraum (1) gasdicht abgedichtet ist,
wobei,
eine der gasdichten Wände (1a-c) in einem Zugangsbereich (1e) durchbrochen ist und dass ein gasdichtes Verbindungselement (14) zwischen dem Zugangsbereich (1e) und dem Hüllenbereich (29) vorliegt, das an seinen Enden mit der gasdichten Wand und der gasdichten Außenhülle (19) jeweils gasdicht verbunden ist, sodass für Wartungszwecke ein bequemer Zugang für das Personal von außerhalb des Sicherheitsraums (1) zum Hüllenbereich (29) und den dortigen Durchführungen (39a-d) besteht,
**dadurch gekennzeichnet dass** der Hüllenbereich (29) der Außenhülle (19) vom Verbindungselement umschlossen wird, so dass der Hüllenbereich (29) außerhalb des Sicherheitsraums (1) liegt.

2. Anlage nach Anspruch 1, **dadurch gekennzeichnet, dass** das zu untersuchende Objekt (10a) kontaminiert ist, und dass der Sicherheitsraum (1) so ausgestaltet ist, dass keine Kontamination aus dem Sicherheitsraum (1) nach außen dringen kann, insbesondere dass er die Spezifikationen nach "Biosafety Level 4" erfüllt.

3. Anlage nach einem der vorhergehenden Ansprüche, **dadurch gekennzeichnet, dass** im Sicherheitsraum (1) gegenüber der Außenatmosphäre Unterdruck herrscht.

4. Anlage nach einem der vorhergehenden Ansprüche, **dadurch gekennzeichnet, dass** der Sicherheitsraum (1) durch mindestens eine Schleuse (3) zugänglich ist.

5. Anlage nach einem der vorhergehenden Ansprüche, **dadurch gekennzeichnet, dass** der Sicherheitsraum (1) mit einem Luftfilterungssystem (1d) ausgestattet oder an ein solches angeschossen ist.

6. Anlage nach einem der vorhergehenden Ansprüche, **dadurch gekennzeichnet, dass** das zu untersuchende Objekt (10a) während der Untersuchung in einem geschlossenen Behälter (10) angeordnet ist.

7. Anlage nach einem der vorhergehenden Ansprüche, **dadurch gekennzeichnet, dass** im Sicherheitsraum (1) Einmal-HF-Antennen (12) vorgesehen sind, die nach Benutzung entsorgt werden.

8. Anlage nach einem der vorhergehenden Ansprüche, **dadurch gekennzeichnet, dass** angrenzend an den Sicherheitsraum (1) ein Bedien- und/oder Wartungsraum (2) vorgesehen, ist, in dem sich eine Konsole (2b) und/oder ein Netzgerät (2a) befinden und wobei die Wand zwischen dem Sicherheitsraum (1) und dem Bedien- und/oder Wartungsraum (2) ein gas- und HF-dichtes Fenster (16) aufweist.

9. Anlage nach einem der vorhergehenden Ansprüche, **dadurch gekennzeichnet, dass** die durchbrochene Wand die Decke (1a) des Sicherheitsraums (1) ist.

10. Anlage nach einem der vorhergehenden Ansprüche, **dadurch gekennzeichnet, dass** das Verbindungselement (14) aus einem ersten Teilverbindungselement (14a) besteht, das fest mit der durchbrochenen Wand (1 a) verbunden ist, sowie aus einem zweiten Teilverbindungselement (14b), das fest mit der gasdichten Außenhülle (19) verbunden ist, und dass die beiden Teilverbindungselemente (14a, 14b) ihrerseits gasdicht verbunden sind.

11. Anlage nach einem der vorhergehenden Ansprüche, **dadurch gekennzeichnet, dass** das Magnetsystem (9) eine supraleitende Magnetspule (9a) umfasst und die gasdichte Außenhülle (19) der Außenmantel eines Magnetkryostaten ist.

12. Anlage nach einem der vorhergehenden Ansprüche, **dadurch gekennzeichnet, dass** die Form des Verbindungselements (14) trichterförmig ist mit einer größeren Öffnung auf der Wandseite.

13. Anlage nach einem der vorhergehenden Ansprüche, **dadurch gekennzeichnet, dass** im Hüllenbereich (29) ein Kaltkopf (39e) eines Refrigerators vorgesehen ist, der durch das Verbindungselement (14) von außerhalb des Sicherheitsraums (1) versorgt, gewartet und/oder ausgetauscht werden kann.

## Claims

1. Installation for investigating objects (10a) using magnetic resonance, comprising:
a safety room (1) having gas-tight walls (1a-c) and a magnet system (9) for generating a homogeneous magnetic field in a volume under investigation (13), wherein the magnet system (9) has a gas-tight outer shell (19) with an area (29) of the shell being interrupted by feedthroughs (39a-d) leading into the interior of the magnet system (9), wherein the magnet system (9) is disposed in the safety room (1) and the shell area (29) is sealed against the safety room (1) in a gas-tight manner,
wherein
one of the gas-tight walls (1a-c) is interrupted in an access area (1e) and a gas-tight connecting element (14) is provided between the access area (1e) and the shell area (29), the ends of which are connected to the gas-tight wall and the gas-tight outer shell (19), respectively, in a gas-tight manner such that the staff can easily access the shell area (29) and the feedthroughs (39a-d) at that location from the outside of the safety room (1) for maintenance purposes,
**characterized in that** the shell area (29) of the outer shell (19) is surrounded by the connecting element such that the shell area (29) is outside of the safety room (1).

2. Installation according to claim 1, **characterized in that** the object (10a) to be investigated is contaminated and the safety room (1) is designed in such a manner that no contamination can penetrate to the outside of the safety room (1), in particular in such a manner that the specifications of "Biosafety Level 4" are met.

3. Installation according to any one of the preceding claims, **characterized in that** low pressure prevails in the safety room (1) relative to an external atmosphere.

4. Installation according to any one of the preceding claims, **characterized in that** the safety room (1) is accessible through at least one lock (3).

5. Installation according to any one of the preceding claims, **characterized in that** the safety room (1) has an air filtering system (1d) or is connected to such a system.

6. Installation according to any one of the preceding claims, **characterized in that** the object (10a) to be investigated is disposed in a closed container (10) during investigation.

7. Installation according to any one of the preceding claims, **characterized in that** single-use RF antennas (12) are provided in the safety room (1), which are disposed of after use.

8. Installation according to any one of the preceding claims, **characterized in that** a control and/or maintenance room (2) is provided adjacent to the safety room (1), the control and/or maintenance room (2) comprising a console (2b) and/or a power supply unit (2a), and wherein the wall between the safety room (1) and the control and/or maintenance room (2) has a gas-tight and RF-tight window (16).

9. Installation according to any one of the preceding claims, **characterized in that** the perforated wall is the ceiling (1a) of the safety room (1).

10. Installation according to any one of the preceding claims, **characterized in that** the connecting element (14) consists of a first partial connecting element (14a) which is firmly connected to the perforated wall (1a), and of a second partial connecting element (14b) which is firmly connected to the gas-tight outer shell (19), and **in that** the two partial connecting elements (14a, 14b) in turn are connected in a gas-tight manner.

11. Installation according to any one of the preceding claims, **characterized in that** the magnet system (9) has a superconducting magnet coil (9a) and the gas-tight outer shell (19) is the outer jacket of a magnet cryostat.

12. Installation according to any one of the preceding claims, **characterized in that** the connecting element (14) has the shape of a funnel with the larger opening being on the wall side.

13. Installation according to any one of the preceding claims, **characterized in that** a refrigerator cold head (39e) is provided in the shell area (29), wherein the cold head can be fed, maintained and/or exchanged from the outside of the safety room (1) via the connecting element (14).

## Revendications

1. Installation destinée à l'analyse d'objets (10a) au moyen de la résonance magnétique, avec une chambre de sécurité (1) qui présente des parois étanches aux gaz (1a-c) et avec un système magnétique (9) servant à générer un champ magnétique homogène dans un volume d'analyse (13), le système magnétique (9) présentant une enveloppe extérieure étanche aux gaz (19) qui est percée dans une zone d'enveloppe (29) par des passages (39a-d) vers l'intérieur du système magnétique (9), le système magnétique (9) étant disposé dans la chambre de sécurité (1) et la zone d'enveloppe (29) étant rendue étanche aux gaz par rapport à la chambre de sécurité (1), une des parois étanches aux gaz (1a-c) étant percée dans une zone d'accès (1e) et un élément de liaison étanche aux gaz (14) étant disposé entre la zone d'accès (1e) et la zone d'enveloppe (29), lequel est relié à ses extrémités à la paroi étanche aux gaz et à l'enveloppe extérieure étanche aux gaz (19) chaque fois de manière étanche aux gaz, de sorte qu'il existe un accès commode à des fins de maintenance pour le personnel à la zone d'enveloppe (29) et aux passages (39a-d) qui s'y trouvent depuis l'extérieur de la chambre de sécurité (1),
**caractérisée en ce**
**que** la zone d'enveloppe (29) de l'enveloppe extérieure (19) est renfermée par l'élément de liaison, de sorte que la zone d'enveloppe (29) se trouve à l'extérieur de la chambre de sécurité (1).

2. Installation selon la revendication 1, **caractérisée en ce que** l'objet à analyser (10a) est contaminé et que la chambre de sécurité (1) est conçue de façon qu'aucune contamination ne puisse sortir de la chambre de sécurité (1) vers l'extérieur, en particulier qu'elle réponde aux spécifications selon « Biosafety Level 4 ».

3. Installation selon une des revendications précédentes, **caractérisée en ce qu'**il règne dans la chambre de sécurité (1) une dépression par rapport à l'atmosphère extérieure.

4. Installation selon une des revendications précédentes, **caractérisée en ce que** la chambre de sécurité (1) est accessible à travers au moins un sas (3).

5. Installation selon une des revendications précédentes, **caractérisée en ce que** la chambre de sécurité (1) est équipée d'un système de filtration d'air (1d) ou raccordée à un tel système.

6. Installation selon une des revendications précédentes, **caractérisée en ce que** l'objet à analyser (10a) est disposé dans un récipient fermé (10) pendant l'analyse.

7. Installation selon une des revendications précédentes, **caractérisée en ce que** dans la chambre de sécurité (1) sont prévues des antennes HF à usage unique (12) qui sont éliminées après utilisation.

8. Installation selon une des revendications précédentes, **caractérisée en ce qu'**il est prévu une chambre de commande et/ou de maintenance (2) adjacente à la chambre de sécurité (1), dans laquelle se trouvent une console (2b) et/ou un bloc d'alimentation (2a), la paroi entre la chambre de sécurité (1) et la chambre de commande et/ou de maintenance (2) présentant une fenêtre étanche aux gaz et aux HF (16).

9. Installation selon une des revendications précédentes, **caractérisée en ce que** la paroi percée est le plafond (1a) de la chambre de sécurité (1).

10. Installation selon une des revendications précédentes, **caractérisée en ce que** l'élément de liaison (14) se compose d'un premier élément de liaison partiel (14a) qui est solidaire de la paroi percée (1a) et d'un deuxième élément de liaison partiel (14b) qui est solidaire de l'enveloppe extérieure étanche aux gaz (19), et que les deux éléments de liaison partiels (14a, 14b) sont eux-mêmes reliés de manière étanche aux gaz.

11. Installation selon une des revendications précédentes, **caractérisée en ce que** le système magnétique (9) comprend une bobine magnétique supraconductrice (9a) et que l'enveloppe extérieure étanche aux gaz (19) est l'enveloppe extérieure d'un cryostat magnétique.

12. Installation selon une des revendications précédentes, **caractérisée en ce que** l'élément de liaison (14) est en forme d'entonnoir avec une ouverture plus grande du côté de la paroi.

13. Installation selon une des revendications précédentes, **caractérisée en ce que** dans la zone d'enveloppe (29), il est prévu une tête froide (39e) d'un réfrigérateur qui peut être alimentée, maintenue et/ou remplacée à travers l'élément de liaison (14) depuis l'extérieur de la chambre de sécurité (1).
